# FASCICULE DE BREVET EUROPEEN

(11) **EP 1 159 776 B1**
(45) Date de publication et mention de la délivrance du brevet: **28.05.2003**
(21) Numéro de dépôt: 00909439.2
(22) Date de dépôt: 07.03.2000
(51) Int. Cl.: H01S 5/026

(54) **SYSTEME OPTOELECTRONIQUE COMPRENANT PLUSIEURS SECTIONS A FONCTIONS RESPECTIVES COUPLEES PAR COUPLAGE EVANESCENT ET PROCEDE DE REALISATION**
OPTISCHES SYSTEM MIT MEHREREN FUNKTIONELLEN SEKTOREN VERBUNDEN DURCH DÄMPFUNGSKOPPLUNG UND HERSTELLUNGSVERFAHREN
OPTOELECTRONIC SYSTEM COMPRISING SEVERAL EVANESCENT FIELD COUPLED SECTIONS WITH RESPECTIVE FUNCTIONS AND METHOD FOR MAKING SAME

(30) Priorité: 08.03.1999 FR 9902822
(43) Date de publication de la demande: 05.12.2001
(73) Titulaire: FRANCE TELECOM, 75015 Paris (FR)
(72) Inventeur: LEGAY, Philippe, F-22700 Louannec (FR); RAMDANE, Abderrahim, F-92330 Sceaux (FR)
(74) Mandataire: Texier, Christian
(86) Numéro de dépôt international: FR0000558
(87) Numéro de publication internationale: WO00054379

(56) Documents cités:
- EP-A- 0 741 316
- EP-A- 0 828 325
- US-A- 4 054 363
- LEE S -L ET AL: "INTEGRATION OF SEMICONDUCTOR LASER AMPLIFIERS WITH SAMPLED GRATING TUNABLE LASERS FOR WDM APPLICATIONS" IEEE JOURNAL OF SELECTED TOPICS IN QUANTUM ELECTRONICS,US,IEEE SERVICE CENTER, vol. 3, no. 2, page 615-627 XP000735962 ISSN: 1077-260X
- CHUANG Z M ET AL: "PHOTONIC INTEGRATED TUNABLE RECEIVERS WITH OPTICAL PREAMPLIFIERS FOR DIRECT DETECTION" APPLIED PHYSICS LETTERS,US,AMERICAN INSTITUTE OF PHYSICS. NEW YORK, vol. 63, no. 7, page 880-882 XP000388128 ISSN: 0003-6951
- KOCH T L ET AL: "HIGH PERFORMANCE TUNABLE 1.5 M INGAAS/INGAASP MULTIPLE QUANTUM WELL DISTRIBUTED BRAGG REFLECTOR LASERS" APPLIED PHYSICS LETTERS,US,AMERICAN INSTITUTE OF PHYSICS. NEW YORK, vol. 53, no. 12, page 1036-1038 XP000020134 ISSN: 0003-6951 cité dans la demande

## Description

La présente invention concerne le domaine de l'optoélectronique.

Elle vise en particulier la réalisation de sources intégrées lasers-guide-modulateurs.

La présente invention peut trouver de nombreuses applications telles que :
. les transmissions optiques haut débit de type NRZ (laser accordable-modulateur) ou RZ (systèmes OTDM)
. la distribution
. la radio sur fibre (réalisation de circuit BLU).

De nombreuses méthodes ont déjà été explorées pour réaliser un couplage actif-passif (par exemple pour une intégration laser modulateur) sur un même substrat.

On peut notamment citer quatre méthodes décrites dans la littérature : 1) le couplage bout à bout, 2) l'épitaxie sélective aux organométalliques, 3) le couplage évanescent et 4) la "structure unique".

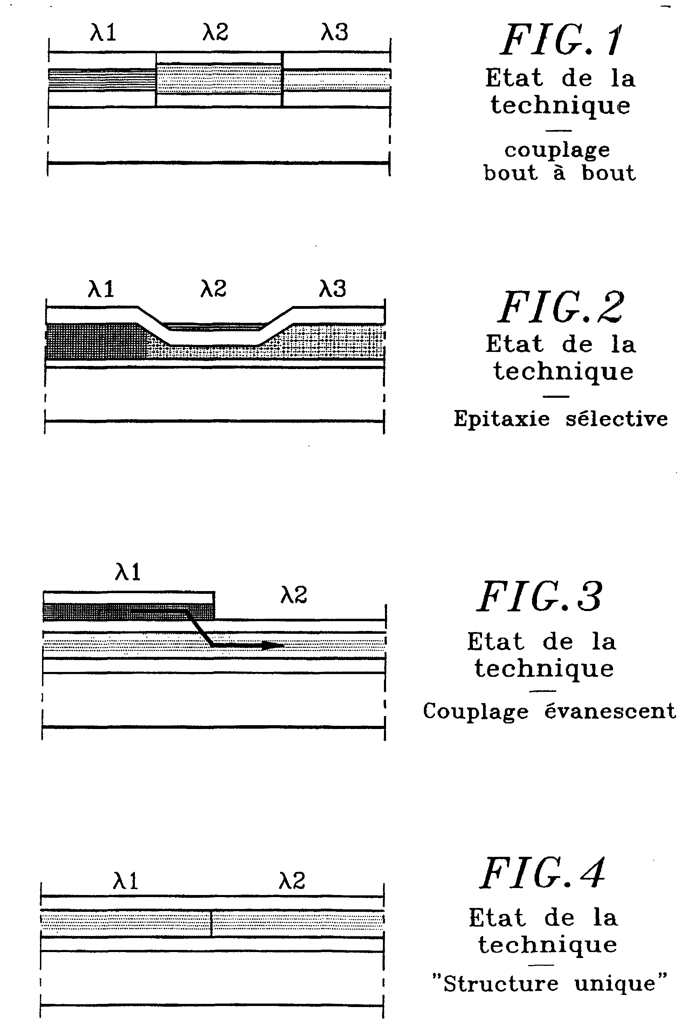

Le couplage bout à bout consiste à épitaxier dans un premier temps une structure de laser, à graver cette première structure aux emplacements dédiés à un modulateur, puis à effecteur ensuite dans ces emplacements, l'épitaxie de la structure du modulateur. Cette technique fait intervenir au moins trois étapes d'épitaxie [1]. Un exemple de structure obtenue avec cette méthode est illustré sur la figure 1 sur laquelle les longueurs d'onde λ1, λ2, λ3 symbolisent les différentes énergies de transition de chaque section.

L'épitaxie sélective aux organométalliques ne demande qu'une seule étape d'épitaxie. Son principe est fondé sur la possibilité de pouvoir modifier localement, par la présence d'un masque de diélectrique de géométrie bien définie, l'épaisseur et la composition du matériau, et de là la longueur d'onde correspondant à la largeur de bande interdite de la zone active de la structure épitaxiée (par référence à celle de la structure sur une zone non masquée) [2]. Il est ainsi possible d'obtenir côte à côte, plusieurs zones possédant des intervalles de bande interdite différents correspondant à autant de fonctions optiques. Pour l'intégration par exemple de lasers DBR-modulateur (DBR ou Distributed Bragg Reflector selon la terminologie anglo-saxonne généralement utilisée, c'est-à-dire laser à réseau de Bragg distribué), ces trois intervalles correspondent à la section active du laser, à une zone de Bragg et à un modulateur. On a illustré sur la figure 2, une vue schématique en coupe d'une croissance par cette méthode d'épitaxie sélective. Sur cette figure 2, l'énergie de transition de chaque section est représentée par sa longueur d'onde équivalente.

Le couplage évanescent (ou vertical) permet la réalisation de deux structures guidantes déposées l'une sur l'autre en une seule étape d'épitaxie. Une gravure permet de dégager les régions où la couche supérieure est indésirable, dégageant ainsi la section modulateur ou guide. Le mode optique reste confiné dans la couche supérieure d'indice de réfraction plus élevé, puis, à partir de l'interface laser-modulateur, va se propager dans la couche inférieure [3], [4]. La figure 3 représente le schéma de principe de la méthode du couplage évanescent. Le mode optique passe d'une couche à l'autre par le jeu des différences d'indice et de la géométrie des guides utilisés.

La méthode dite "structure unique" consiste à utiliser un même empilement à multipuits quantiques pour chacune des sections du composant (3 si il s'agit de l'intégration laser DBR-modulateur) [5], [6]. Elle s'appuie sur les effets d'élargissement du spectre de gain optique pour des semi-conducteurs contraints lorsqu'on y injecte des porteurs. Cette propriété permet d'obtenir un effet d'amplification optique et donc une émission laser pour une énergie plus faible que l'énergie de transition (du semi-conducteur sans porteurs injectés). La compatibilité en longueur d'onde entre le laser et le modulateur (typiquement 1.55µm pour le laser et 1.50µm pour le modulateur) est obtenue par un léger décalage vers le rouge de la longueur d'onde de Bragg. La figure 4 représente un schéma de principe de la structure unique. La différence d'énergie de transition entre les deux sections est obtenue par rétrécissement de l'intervalle de bande interdite lors de l'injection de porteurs.

Toutes ces techniques connues semblent présenter chacune des intérêts intrinsèques. Cependant aucune ne donne véritablement satisfaction.

Concernant le couplage bout à bout, le principal avantage est l'optimisation des deux structures séparément. En contrepartie, la méthode implique une bonne maîtrise de la gravure et de la reprise d'épitaxie sur un substrat non préparé pour une épitaxie, de manière à aligner les couches des différentes sections les unes par rapport aux autres. De plus, le couplage entre les deux sections est responsable de pertes et de réflexions pouvant perturber le fonctionnement de sources intégrées à haute fréquence. D'autre part, le procédé nécessite plusieurs étapes d'épitaxie, ce qui a un coût.

L'épitaxie localisée permet d'obtenir d'excellents résultats en terme d'intégration de composants. Les pertes de couplage entre les différentes sections sont dans ce cas très faibles et les intervalles de bande interdite des différentes sections peuvent être ajustés à des valeurs précises en fonction du masque (par exemple à base de nitrure de silicium) utilisé. Toutefois son principal inconvénient vient du fait que le même type de structure est utilisé pour chaque section du composant. A l'inverse du couplage bout à bout, on ne peut donc pas ajuster séparément les structures de chaque section du composant. Par exemple, pour l'intégration de laser DBR-modulateur, l'accordabilité maximale qui peut être obtenue est limitée par le fait que l'épaisseur de la section de Bragg est obligatoirement plus faible que celle de la zone active du laser. D'autre part, une étape critique de préparation de surface est également nécessaire.

Concernant le couplage évanescent, le principal avantage est l'optimisation quasi indépendante de deux sections du composant (structure inférieure et structure supérieure). D'autre part, c'est une technique relativement simple à mettre en oeuvre. En contrepartie, il est délicat d'intégrer plus de deux sections différentes. Ceci est un handicap dans le cas par exemple de l'intégration DBR-modulateur où trois sections sont nécessaires.

Le principal avantage de la "structure unique "est sa simplicité. Toutefois, comme pour l'épitaxie sélective, les différentes sections ne peuvent être optimisées séparément. Il en résulte un compromis qui ne permet l'intégration que de fonctions optiques présentant un décalage en longueur d'onde relativement faible (laser-modulateur, modulateur-amplificateur ...). L'intégration d'un laser avec un guide passif est impossible car elle demande un décalage en longueur d'onde trop important.

Le document US-4054363 décrit un guide formé d'une hétérostructure du type circuit intégré optique muni d'un élément film fin tel qu'un laser semi-conducteur couplé à travers un coupleur directionnel à un guide présentant de faible perte en transmission.

Le document CHUANG Z M et al. "Photonic integrated tunable receivers with optical preamplifiers for direct détection" applied physics letters, US, American Institute of Physics, New York, vol. 63, n°7, pages 880-882 décrit un récepteur photonique accordable intégré qui comprend en série un préamplificateur optique, un coupleur codirectionnel forment filtre et un photodétecteur.

La présente invention a maintenant pour but de proposer de i nouveaux moyens permettant d'intégrer, par une technique simple compatible avec des procédés industriels, au minimum trois sections d'énergies de bande interdite différentes avec si possible des structures optimisées pour chaque section.

L'intégration par couplage évanescent ne permet d'intégrer que deux sections optimisées. Intégrer trois sections différentes avec des structures optimisées pour chacune est théoriquement possible avec le couplage bout à bout, mais trois étapes d'épitaxies sont nécessaires dans ce cas, avec des inconvénients qui ont été précédemment évoqués. L'épitaxie sélective aux organométalliques permet d'intégrer trois sections différentes mais dans ce cas, les structures ne peuvent être optimisées de façon indépendante. Le même raisonnement est valable pour la structure unique. Il est vrai que dans ce cas, l'intégration laser DFB-modulateur (2 sections) a montré de très bons résultats (DFB pour "Distributed Feedback", c'est-à-dire un laser équipé d'un réseau de Bragg périodique). Mais les choses se compliquent si l'on veut intégrer le modulateur avec un laser accordable (DBR) sur une plage d'accordabilité par exemple de 10nm. Dans ce cas, une troisième section spécifique (section de Bragg) doit être introduite entre la zone active du laser et le modulateur.

Le but précité est atteint selon la présente invention grâce à un système optoélectronique comprenant au moins trois sections correspondant à des fonctions respectives spécifiques et présentant des énergies de bande interdite respectives, différentes, au moins pour les paires adjacentes de sections, constituées, d'au moins deux couches superposées par une épitaxie, la couche supérieure étant gravée pour définir lesdites sections sous forme de deux sections d'extrémité séparées limitées dans la couche supérieure de part et d'autre d'une section intermédiaire définie dans la couche inférieure, et permettre un couplage entre la section intermédiaire et chacune des sections d'extrémité qui l'encadrent, par couplage évanescent, dans lequel la longueur "L" de la section intermédiaire, dans laquelle est gravé un réseau de Bragg, est telle que le produit K.L. (où K est le coefficient de couplage du réseau) est de l'ordre de 1.

Par exemple pour K de l'ordre de 50cm⁻¹, cette longueur L est de l'ordre de 200µm.

La présente invention concerne également un procédé de réalisation du système précité.

Le concept précité conforme à la présente invention permet de réaliser, avec une technologie simple et industrialisable, des lasers accordables sur plus de 10nm, des sources solitons, des tandems de modulateurs, des sources intégrées pour la BLU etc ...

D'autres caractéristiques, buts et avantages de la présente invention apparaîtront à la lecture de la description détaillée qui va suivre et en regard des dessins annexés, donnés à titre d'exemples non limitatifs et sur lesquels :
- les figures 1 à 4 précédemment décrites illustrent quatre méthodes conformes à l'état de la technique,
- les figures 5 illustrent schématiquement une structure conforme à la présente invention à diverses étapes de son processus de fabrication,
- la figure 6 illustre schématiquement une source pour transmission Rz conforme à la présente invention, et
- la figure 7 illustre une structure épitaxiée conforme à la présente invention pour la réalisation d'un laser DBR.

Comme indiqué précédemment, dans le cadre de la présente invention, on associe un couplage évanescent et la méthode de la couche active unique pour réaliser une structure incluant un laser, un guide passif et un ou plusieurs modulateurs.

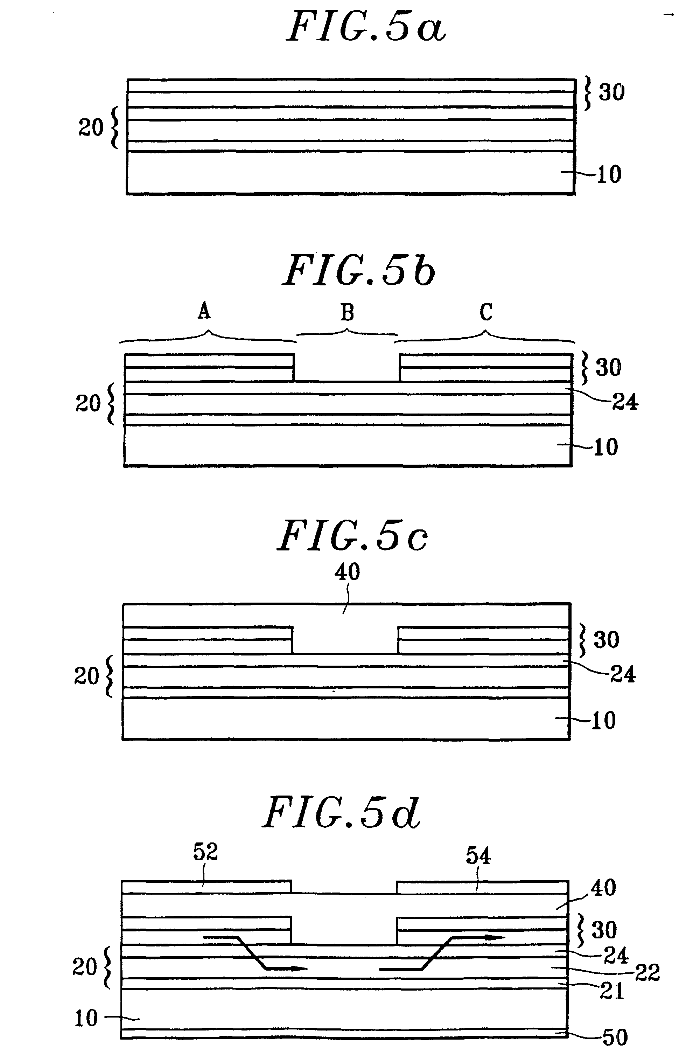

Plus précisément encore, de préférence, pour réaliser une structure conforme à la présente invention, comme schématisé sur les figures 5, on procède essentiellement comme suit :
i) dans une première étape comme illustré sur la figure 5a, on procède par épitaxie au dépôt successif sur un substrat 10 de deux ensembles de couches 20 et 30. Ces deux ensembles de couches 20, 30 peuvent par exemple correspondre respectivement à la structure optimisée d'une section guide (section de Bragg par exemple pour un laser DBR) et à celle, à base de multipuits quantiques contraints, optimisée pour l'intégration laser -modulateur,
ii) dans une deuxième étape, comme illustré sur la figure 5b, l'ensemble de couches supérieures 30 ainsi épitaxiées est gravé jusqu'à une couche d'arrêt 24 située au sommet de l'ensemble inférieur 20, aux emplacements de la section guide, formant la section intermédiaire précitée, par exemple la section de Bragg dans le cas d'un laser DBR. On observera sur la figure 5b, qu'à la fin de cette étape de gravure, les deux sections d'extrémité sont ainsi clairement individualisées. Sur la figure 5b, ces deux sections d'extrémité, qui peuvent servir respectivement de source laser DFB et de modulateur sont référencées A et C, entre la section intermédiaire B mise à jour dans l'ensemble de couches inférieures 20.
iii) Le cas échéant, un traitement spécifique peut alors être opéré sur la section intermédiaire B, par exemple gravure du réseau de Bragg dans l'ensemble inférieur de couches 20 dans le cas d'un laser DBR.
iv) Comme illustré sur la figure 5c, on procède ensuite à une reprise d'InP p+, ou d'un matériau équivalent (schématisé sous la référence 40), sur la plaque entière.
v) Puis comme illustré sur la figure 5d, l'on procède à une formation d'électrodes sur la surface inférieure du substrat (référence 50) et sur les couches supérieures des sections d'extrémité (références 52 et 54), après avoir réalisé, le cas échéant, une gravure de ruban dans l'empilement des couches de la zone active.

L'électrode métallique 50 formée sur la surface inférieure du substrat 10 est destinée à être portée au potentiel de la masse.

Les électrodes 52 et 54 sont destinées à être reliées à des générateurs de tension respectifs adéquats pour polariser de manière convenable respectivement les deux sections A et C.

La structure constituée par les couches supérieures 30, d'énergie de transition située autour de 1,50µm, possède des puits quantiques contraints. Son spectre de gain, lors de l'injection de courant est donc assez plat autour de 1,50µm y compris vers les plus fortes longueurs d'ondes (renormalisation de bande interdite). Un décalage vers les faibles énergies est donc possible comme décrit dans les documents [5] et [6]. Une émission laser à plus faible énergie (par exemple 1,55µm) dépend de la période du réseau de Bragg définie dans la zone intermédiaire B.

On notera que l'indice équivalent de l'ensemble supérieur 30 est supérieur à celui de l'ensemble inférieur 20. Il est également nécessaire que la section guide réalisée dans l'ensemble inférieur 20 soit transparente à la longueur d'onde du laser A.

Le mode optique émis par la section A formant source laser se propage principalement dans l'ensemble de couches supérieures 30 puis passe dans la structure guide formée par l'ensemble de couches inférieures 20, au niveau de la section intermédiaire B, lorsque la structure active 30 disparaît.

Une simulation par logiciel de cette structure indique que l'on obtient des coefficients de couplage proches de 90% lors de la transition du mode optique se propageant initialement principalement dans l'ensemble supérieur 30 au niveau de la section A, vers la structure guide constituée par l'ensemble inférieur 20 au niveau de la section B.

A la sortie de la section de guide B/20, la structure 30 est de nouveau présente et le mode optique repasse majoritairement dans celle-ci, au niveau de la section d'extrémité C où l'effet Stark confiné peut permettre de moduler son intensité.

Le coefficient de couplage simulé, lors de cette transition de la structure guide 20 vers la structure modulateur 30 est aussi proche de 90%.

Ainsi, le procédé conforme à la présente invention, comportant une seule étape d'épitaxie et incluant un procédé technologique très simple permet d'effectuer l'intégration d'un modulateur avec un laser accordable sur une plage d'accordabilité étendue (typiquement supérieure à 10nm), ne dépendant que du coefficient de confinement du mode optique dans la section guide B/20 (c'est à dire la section de Bragg pour un laser DBR).

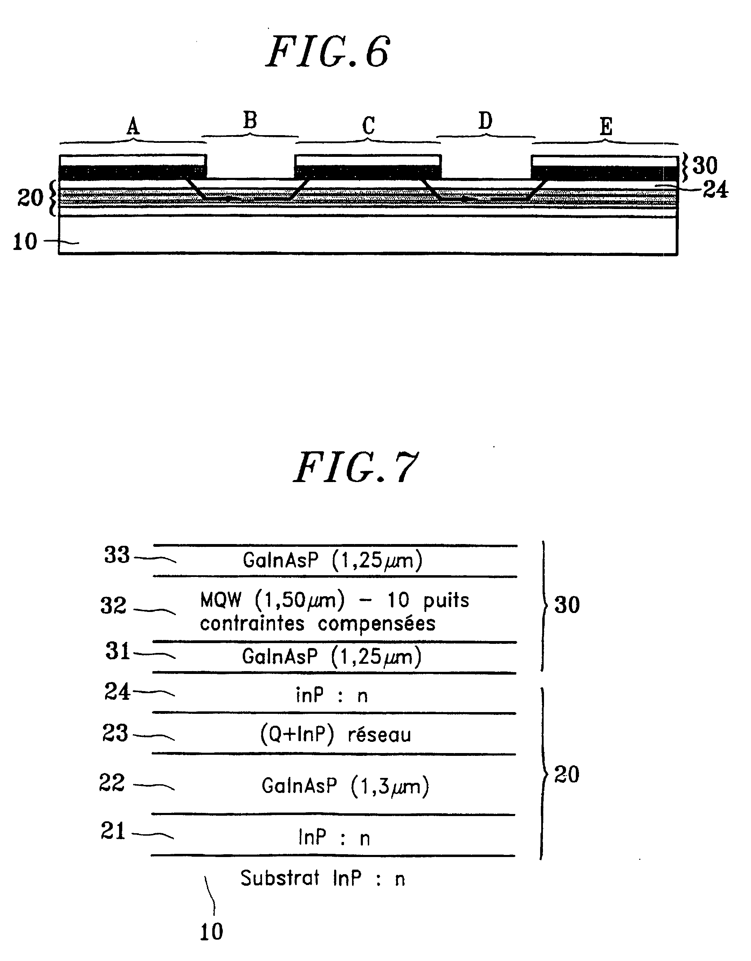

On a illustré sur la figure 6, une autre famille d'application concernant les sources laser DFB-modulateur(s) où l'ensemble de couches 20 est utilisé comme guide passif centré autour de 1,3µm pour éviter les pertes optiques.

Ainsi, on aperçoit sur la figure 6, une structure comprenant sur un substrat 10 un premier ensemble de couches 20 formant guide passif, sur lequel sont superposées trois sections A, C et E délimitées par gravure dans un second ensemble de couches 30, pour délimiter respectivement une première section intermédiaire B et une deuxième section intermédiaire D respectivement entre les sections actives A, C et E précitées. La section A sert de laser DFB, la section C peut servir de premier modulateur formant générateur d'impulsions et la section E peut servir de second modulateur à des fins de codage.

Dans cette structure le mode émis par la section A formant source passe, par couplage évanescent dans la section B de la structure guide 20, remonte par couplage évanescent dans la section C formant modulateur réalisé dans l'ensemble 30, repasse par couplage évanescent dans la section D de la structure guide 20, à la sortie de la section C, puis remonte, toujours par couplage évanescent dans le second modulateur formé par la section E de l'ensemble 30.

On obtient ainsi une source pour transmissions RZ.

Le même principe peut être appliqué pour la réalisation d'une source de type BLU pour les applications radio sur fibres impliquant l'intégration d'un laser DFB et de deux modulateurs couplés à l'aide d'un circuit optique passif.

Comme on l'a indiqué précédemment, pour permettre le couplage évanescent précité entre les différentes sections de la structure formées dans les deux ensembles 20 et 30 superposés, il est important dans le cadre de l'invention que la longueur "L" de la section intermédiaire B ou D, dans laquelle est gravé un réseau de Bragg (notamment dans la configuration Iser-DBR), soit telle que le produit K.L. (où K est le coefficient de couplage du réseau) est de l'ordre de 1. Par exemple pour K de l'ordre de 50cm⁻¹, cette longueur L est de l'ordre de 200µm.

Ainsi dans le cadre de la présente invention, on prévoit typiquement des sections intermédiaires B, D d'une longueur L comprise entre 50 et 800µm, préférentiellement entre 100 et 500µm et très avantageusement entre 150 et 400µm.

Le procédé de réalisation de la structure illustrée sur la figure 6 est globalement identique à celui précédemment décrit en regard de la figure 5.

On va maintenant décrire un exemple particulier de structure épitaxiée conforme à la présente invention pour la réalisation d'un laser DBR en regard de la figure 7.

Selon l'exemple illustré sur cette figure 7, le substrat 10 est de type InP : n, et le premier ensemble de couches 20 est constitué par dépôts successifs d'une couche 21 d'InP : n , d'une couche 22 de GalnAsP (1,3µm) d'une épaisseur typique de l'ordre de 400,0 nm (4000Å) (le cas échéant une telle couche peut également être formée de multipuits quantiques), d'une couche 23 à base de InGaAsP, destinée à former un réseau, d'une épaisseur typique de l'ordre de 50,0nm 500 Å/et d'une couche 24 d'arrêt à base d'InP : n d'une épaisseur typique de l'ordre de 20,0nm (200 Å) tandis que le second ensemble de couches 30 est formé de la superposition d'une couche 31 à base de GalnAsP (1,25µm) d'une épaisseur typique de l'ordre de 30,0nm (300 Å), d'une couche 32 à multipuits quantiques (1,50µm) (par exemple 10 puits) d'une épaisseur typique de l'ordre de 143,0 nm (1430 Å) et d'une couche 33 de couverture en GalnAsP (1,25µm) d'une épaisseur typique de l'ordre de 30,0 µm (300 Å).

Les enchaînements technologiques pour réaliser un système optoélectrique à partir de cet empilement de couches épitaxiées sont :
1. Gravure de la structure supérieure 30 jusqu'à la couche d'arrêt 24 (InP : n) aux emplacements des sections B et D.
2. Gravure du réseau de Bragg dans la section de Bragg au pas calculé pour l'émission laser à 1.55µm.
3. Reprise d'épitaxie pleine plaque : InP : p (1.8µm) + GaInAs : p ++ (0.3µm) (comparable à la couche 40 de la figure 5).
4. Gravure d'un ruban de 2µm de large. La structure "guide d'onde en arrête" permet ainsi d'obtenir de faibles capacités pour les hauts débits.
5. Implantation - séparation d'électrodes (comparables aux électrodes 50, 52 et 54 de la figure 5).
6. Métallisation.

Une simulation d'une telle structure montre que le coefficient de couplage entre la section laser A et la section de Bragg B est de 90% et le confinement du mode dans la section de Bragg est de 42%. Cette dernière valeur est compatible avec une accordabilité sur 10nm. On retrouve ensuite le même coefficient de couplage lors du passage du mode de la section de Bragg B vers le modulateur C qui est centré à 1.50µm alors que l'émission laser est à 1.55µm.

Les caractéristiques de modulation seront donc bonnes.

Bien entendu la présente invention n'est pas limitée au mode de réalisation particulier qui vient d'être décrit.
[1] T. Tanbun-eK, S. Susuki, W. Shu Min, Y. Suematsu, S. Sarai, IEEE J. Quant. Electron., Vol 20, 1984, p.131
[2] Y. Katoh, K. Yamada, T. Kunii, Yoh Ogawa, IEICE Trans. Electron., Vol.E80-C, 1997,p. 69
[3] T.L. Koch, U. Koren, B.I. Miller, Appl. Phys. Lett., Vol. 53, 1988, p. 1036
[4] U. Koren, B. Glance, B.I. Miller, M.G. Young, M. Chien, T.H. Wood, L.M. Ostar, T.L. Koch, R.M. Jopson, J.D. Evankow, G. Raybon, C.A. Burrus, P.D. Magill, K.C. Reichmann, Tech. Dig. Opt. Fib. Communication conference (OFC 92), San Jose, CA, p. 124.
[5] Brevet FR-A-2706079.
[6] A. Ramdane, F. Devaux, N. Souli, D. Delprat, A. Ougazzaden, IEEE, J. select. Topics in Quantum Electronics, Vol.2, 1996, p. 326.

## Revendications

1. Système optoélectronique comprenant au moins trois sections (A, B, C) correspondant à des fonctions respectives spécifiques et présentant des énergies de bandes interdites respectives différentes, au moins pour les paires adjacentes de sections, ces trois sections étant constituées d'au moins deux couches (20, 30) superposées par épitaxie, la couche supérieure (30) étant gravée pour définir lesdites sections sous forme de deux sections d'extrémités (A, C) séparées, limitées dans la couche supérieure (30) de part et d'autre d'une section intermédiaire (B) définie dans la couche inférieure (20), et permettant un couplage par couplage évanescent entre la section intermédiaire (B) et chacune des sections d'extrémités (A, C) qui l'encadrent **caractérisé par le fait que** la longueur (L) de la section intermédiaire (B) est telle que le produit (K.L) dans lequel (K) représente le coefficient de couplage d'un réseau de la section intermédiaire (B) est de l'ordre de 1.

2. Système selon la revendication 1, **caractérisé par le fait que** la longueur (L) de la section intermédiaire (B) est comprise entre 50 et 800µm, préférentiellement entré 100 et 500µm, très avantageusement entre 150 et 400µm et très préférentiellement de l'ordre de 200µm.

3. Système selon l'une des revendications 1 à 2, caradérisé par le fait que la section intermédiaire (B) comprend un réseau de Bragg.

4. Système selon l'une des revendications 1 à 3, **caractérisé par le fait que** la couche supérieure (30) comporte trois sections (A, C et E) disposées respectivement de part et d'autre de deux sections intermédiaires (B et D) prévues dans l'ensemble de couche inférieurs (20).

5. Système selon l'une des revendications 1 à 4, **caractérisé par le fait qu'**il constitue une source intégrée laser-guide-modulateur.

6. Système selon l'une des revendications 1 à 4, **caractérisé par le fait qu'**il constitue un dispositif choisi dans le groupe comprenant des moyens de transmission optiques au débit de type NRZ ou RZ, des moyens de distribution, ou des moyens de radio sur fibres tels que circuit BLU.

7. Système selon l'une des revendications 1 à 6, **caractérisé par le fait que** l'ensemble de couches inférieures (20) constitue un guide passif centré autour de 1,3µm.

8. Système selon l'une des revendications 1 à 7, **caractérisé par le fait qu'**il comprend deux modulateurs (C et E) dans l'ensemble de couches supérieures (30) : un premier modulateur (C) formant générateur d'impulsions et un second modulateur (E) servant au codage.

9. Système selon l'une des revendications 1 à 8, **caractérisé par le fait que** l'ensemble (20) de couche inférieure comprend une couche active à base de GaInAsP.

10. Système selon l'une des revendications 1 à 8, **caractérisé par le fait que** l'ensemble de couche inférieure (20) constitue une couche active à base de multipuits quantiques.

11. Système selon l'une des revendications 1 à 10, **caractérisé par le fait que** l'ensemble de couche inférieure (20) comprend une couche active (22) encadrée de deux couches (21,23) à base d'lnP.

12. Système selon l'une des revendications 1 à 11, **caractérisé par le fait que** l'ensemble de couches inférieures (20) est revêtu d'une couche d'arrêt (24), par exemple à base d'InP.

13. Système selon l'une des revendications 1 à 12, **caractérisé par le fait que** l'ensemble de couches supérieures (30) comprend une couche active (32) à base de multipuits quantiques.

14. Système selon l'une des revendications 1 à 13, **caractérisé par le fait que** l'ensemble de couche supérieure (30) comprend une couche active (32) encadrée par des couches (31, 33) à base de GaInAsP.

15. Procédé de réalisation d'un système conforme à l'une des revendications 1 à 14, **caractérisé par le fait qu'**il comprend des étapes consistant à :
i) déposer sur un substrat (10), par épitaxie, deux ensembles de couches (20, 30) superposés,
ii) graver l'ensemble de couches supérieures (30) jusqu'à une couche d'arrêt (24) située au sommet de l'ensemble inférieur (20) pour individualiser ainsi au moins deux sections d'extrémité (A, C) dans l'ensemble de couches supérieures (30) de manière à permettre un couplage évanescent entre la section intermédiaire (B) et chacune des sections d'extrémités (A, C) qui l'encadre.

16. Procédé selon la revendication 15, **caractérisé par le fait qu'**il comprend en outre l'étape consistant à opérer un traitement spécifique sur la section intermédiaire (B).

17. Procédé selon la revendication 16, **caractérisé par le fait que** le traitement spécifique consiste à graver un réseau de Bragg dans la section intermédiaire (B).

18. Procédé selon l'une des revendications 15 à 17, **caractérisé par le fait qu'**il comprend en outre l'étape consistant à opérer une reprise d'un matériau, par exemple à base d'InP sur la plaque entière du système.

19. Procédé selon l'une des revendications 15 à 18, **caractérisé par le fait qu'**il comprend en outre l'étape consistant à déposer des électrodes sur la surface inférieure du substrat et sur la surface supérieure des sections d'extrémités (A, C, E).

## Patentansprüche

1. Optoelektronisches System mit wenigstens drei Sektoren (A, B, C), die jeweils spezifischen Funktionen entsprechen und bei denen wenigstens die jeweils benachbarten Sektoren verschiedene Bandlücken aufweisen, wobei die drei Sektoren wenigstens zwei übereinanderliegende epitaktische Schichten (20, 30) umfassen und die obere Schicht (30) mit Einschnitten versehen ist, so dass die Sektoren als zwei Randsektoren (A, C) abgetrennt sind, die in der oberen Schicht (30) beidseitig von einem Zwischensektor (B) in der unteren Schicht (20) begrenzt werden, und eine Kopplung als gedämpfte Kopplung zwischen dem Zwischensektor (B) und jedem der ihn einschließenden Randsektoren (A, C) ermöglicht wird, **dadurch gekennzeichnet, dass** die Länge (L) des Zwischensektors (B) derart gewählt ist, dass das Produkt (K · L), bei dem (K) dem Kopplungskoeffizienten in einem Zwischensektorgitter (B) entspricht, in der Ordnung von 1 liegt.

2. System nach Anspruch 1, **dadurch gekennzeichnet, dass** die Länge (L) des Zwischensektors (B) zwischen 50 und 800µm, vorzugsweise zwischen 100 und 500µm, stärker bevorzugt zwischen 150 und 400µm und besonders bevorzugt in der Ordnung von 200µm liegt.

3. System nach Anspruch 1 oder 2, **dadurch gekennzeichnet, dass** der Zwischensektor (B) ein Bragg-Gitter umfasst.

4. System nach einem der Ansprüche 1 bis 3, **dadurch gekennzeichnet, dass** die obere Schicht (30) drei Sektoren (A, C, E) umfasst, die jeweils beidseitig der beiden Zwischensektoren (B, D) in der Gruppe der unteren Zwischensektoren (20) vorgesehen sind.

5. System nach einem der Ansprüche 1 bis 4, **dadurch gekennzeichnet, dass** es einen integrierten Laser-Modulator bildet.

6. System nach einem der Ansprüche 1 bis 4, **dadurch gekennzeichnet, dass** es eine Einrichtung unter anderem in der Art einer optischen NRZ- oder RZ-Übertragungsvorrichtung, einer Verteilervorrichtung oder einer Kabelrundfunkvorrichtung wie BLU darstellt.

7. System nach einem der Ansprüche 1 bis 6, **dadurch gekennzeichnet, dass** die Gruppe der unteren Schichten (20) einen passiven Leiter im Bereich um 1,3µm herum bilden.

8. System nach einem der Ansprüche 1 bis 7, **dadurch gekennzeichnet, dass** es zwei Modulatoren (C, E) in der Gruppe der oberen Schichten (30) umfasst: einen ersten Modulator (C), der einen Impulsgenerator darstellt, und einen zweiten Modulator (E), der zum Kodieren dient.

9. System nach einem der Ansprüche 1 bis 8, **dadurch gekennzeichnet, dass** die Gruppe der unteren Schichten (20) eine aktive Schicht aus GaInAsP aufweist.

10. System nach einem der Ansprüche 1 bis 8, **dadurch gekennzeichnet, dass** die Gruppe der unteren Schichten (20) eine aktive Schicht mit Multi-Quantum-Wells aufweist.

11. System nach einem der Ansprüche 1 bis 10, **dadurch gekennzeichnet, dass** die Gruppe der unteren Schichten (20) eine aktive Schicht (22) zwischen zwei Schichten (21, 23) aus InP umfasst.

12. System nach einem der Ansprüche 1 bis 11, **dadurch gekennzeichnet, dass** die Gruppe der unteren Schichten (20) bedeckt ist mit einer Stopschicht (24), die beispielsweise aus InP besteht.

13. System nach einem der Ansprüche 1 bis 12, **dadurch gekennzeichnet, dass** die Gruppe der oberen Schichten (30) eine aktive Schicht (32) mit Multi-Quantum-Wells umfasst.

14. System nach einem der Ansprüche 1 bis 13, **dadurch gekennzeichnet, dass** die Gruppe der oberen Schichten (30) eine aktive Schicht (32) zwischen Schichten (31, 33) aus GaInAsP umfasst.

15. Verfahren zum Herstellen eines Systems nach einem der Ansprüche 1 bis 14, **gekennzeichnet durch** die folgenden Schritte:
i) epitaktisches Erzeugen einer Gruppe von zwei übereinanderliegenden Schichten (20, 30) auf einem Substrat (10),
ii) Erzeugen von Einschnitten in der Gruppe der oberen Schichten (30) bis zu einer Stopschicht (24) oben auf der unteren Gruppe (20) zum Separieren von wenigstens zwei Randsektoren (A, C) in der Gruppe der oberen Schichten (30), so dass eine gedämpfte Kopplung zwischen dem Zwischensektor (B) und jedem der ihn umgebenden Randsektoren (A, C) ermöglicht wird.

16. Verfahren nach Anspruch 15, **gekennzeichnet durch** den weiteren Schritt: Durchführen einer Spezialbehandlung des Zwischensektors (B).

17. Verfahren nach Anspruch 16, **dadurch gekennzeichnet, dass** die Spezialbehandlung ein Erzeugen von Einschnitten in einem Bragg- Gitter in dem Zwischensektor (B) umfasst.

18. Verfahren nach einem der Ansprüche 15 bis 17, **gekennzeichnet durch** den weiteren Schritt: Aufbringen eines Materials, beispielsweise aus InP, auf der gesamten Scheibe des Systems.

19. Verfahren nach einem der Ansprüche 15 bis 18, **gekennzeichnet durch** den weiteren Schritt: Anordnen von Elektroden auf der unteren Oberfläche des Substrats und auf der oberen Oberfläche der Randsektoren (A, C, E).

## Claims

1. Optoelectronic system comprising at least three sections (A, B, C) corresponding to specific respective functions and having different respective band gap energies, at least for the adjacent pairs of sections, these three sections consisting of at least two layers (20, 30) superposed by epitaxy, the upper layer (30) being etched in order to define the said sections in the form of two separate end sections (A, C), defined in the upper layer (30) on each side of an intermediate section (B) defined in the lower layer (20), and allowing coupling by evanescent coupling between the intermediate section (B) and each of the end sections (A, C) which flank it, **characterized in that** the length (L) of the intermediate section (B) is such that the product (K×L), in which (K) represents the coupling coefficient of a grating of the intermediate section (B), is of the order of 1.

2. System according to Claim 1, **characterized in that** the length (L) of the intermediate section (B) is between 50 and 800 µm, preferably between 100 and 500 µm, very advantageously between 150 and 400 µm and very preferably about 200 µm.

3. System according to one of Claims 1 to 2, **characterized in that** the intermediate section (B) comprises a Bragg grating.

4. System according to one of Claims 1 to 3, **characterized in that** the upper layer (30) comprises three sections (A, C and E) placed respectively on each side of two intermediate sections (B and D) provided in the lower multilayer (20).

5. System according to one of Claims 1 to 4, **characterized in that** it constitutes an integrated laser-guide-modulator source.

6. System according to one of Claims 1 to 4, **characterized in that** it constitutes a device chosen from the group comprising optical transmission means with NRZ or RZ type output, distribution means or radio-on-fibre means such as a BLU circuit.

7. System according to one of Claims 1 to 6, **characterized in that** the lower multilayer (20) constitutes a passive guide centred around 1.3 µm.

8. System according to one of Claims 1 to 7, **characterized in that** it comprises two modulators (C and E) in the upper multilayer (30), a first modulator (C) forming a pulse generator and a second modulator (E) serving for coding.

9. System according to one of Claims 1 to 8, **characterized in that** the lower multilayer (20) comprises a GaInAsP-based active layer.

10. System according to one of Claims 1 to 8, **characterized in that** the lower multilayer (20) constitutes an active layer based on multiple quantum wells.

11. System according to one of Claims 1 to 10, **characterized in that** the lower multilayer (20) comprises an active layer (22) flanked by two InP-based layers (21, 23).

12. System according to one of Claims 1 to 11, **characterized in that** the lower multilayer (20) is coated with a stop layer (24), for example based on InP.

13. System according to one of Claims 1 to 12, **characterized in that** the upper multilayer (30) comprises an active layer (32) based on multiple quantum wells.

14. System according to one of Claims 1 to 13, **characterized in that** the upper multilayer (30) comprises an active layer (32) flanked by GaInAsP-based layers (31, 33).

15. Process for producing a system according to one of Claims 1 to 14, **characterized in that** it comprises steps consisting in:
i) depositing two superposed multilayers (20, 30) on a substrate (10) by epitaxy;
ii) etching the upper multilayer (30) down to a stop layer (24) located at the top of the lower multilayer (20) in order thus to separate at least two end sections (A, C) in the upper multilayer (30) so as to allow evanescent coupling between the intermediate section (B) and each of the end sections (A, C) which flanks it.

16. Process according to Claim 15, **characterized in that** it furthermore includes the step consisting in carrying out a specific treatment on the intermediate section (B).

17. Process according to Claim 16, **characterized in that** the specific treatment consists in etching a Bragg grating in the intermediate section (B).

18. Process according to one of Claims 15 to 17, **characterized in that** it furthermore includes the step consisting in depositing a material, for example based on InP, over the entire wafer of the system.

19. Process according to one of Claims 15 to 18, **characterized in that** it furthermore includes the step consisting in depositing electrodes on the lower surface of the substrate and on the upper surface of the end sections (A, C, E).
